Europäisches Patentamt

European Patent Office

Office européen des brevets

(11) Numéro de publication : **0 377 388 B1**

## (12) FASCICULE DE BREVET EUROPEEN

(45) Date de publication du fascicule du brevet :
**10.03.93 Bulletin 93/10**

(51) Int. Cl.⁵ : **H03B 5/20**

(21) Numéro de dépôt : **89420518.6**

(22) Date de dépôt : **26.12.89**

(54) **Générateur de forme d'onde de signal analogique.**

(30) Priorité : **28.12.88 FR 8817577**

(43) Date de publication de la demande :
**11.07.90 Bulletin 90/28**

(45) Mention de la délivrance du brevet :
**10.03.93 Bulletin 93/10**

(84) Etats contractants désignés :
**DE FR GB IT NL**

(56) Documents cités :
**EP-A- 0 132 885**
**EP-A- 0 171 678**
**EP-A- 0 228 941**

(56) Documents cités :
**IEEE JOURNAL OF SOLID-STATE CIRCUITS,
vol. SC-18, no. 4, août 1983, pages 383-389,
IEEE, New York, US; D.B. COX: "A digitally
programmable switched-capacitor universal
active filter/oscillator"
PATENT ABSTRACTS OF JAPAN, vol. 11, no.
113 (E-497)[2560], 6 avril 1987; & JP-A-61 261
949**

(73) Titulaire : **SGS-THOMSON
MICROELECTRONICS S.A.
7, Avenue Galliéni
F-94250 Gentilly (FR)**

(72) Inventeur : **Fensch, Thierry
64bis, Cours Jean Jaurès
F-38000 Grenoble (FR)**

(74) Mandataire : **de Beaumont, Michel
1bis, rue Champollion
F-38000 Grenoble (FR)**

EP 0 377 388 B1

## Description

L'invention concerne un générateur de forme d'onde de signal électrique analogique.

Le but d'un tel dispositif est de produire un signal électrique analogique de forme bien déterminée à partir d'informations numériques appliquées sous forme de séquences de mots numériques, chaque mot représentant un incrément du signal analogique.

Dans un exemple de réalisation, on peut envisager que les mots aient trois bits chacun, de sorte qu'il y a au plus six valeurs d'incréments possibles pour le signal analogique. Le générateur reçoit périodiquement un mot de trois bits, et le signal de sortie s'incrémente d'une valeur qui dépend de la valeur du mot.

Avant de décrire la structure générale du générateur, on va donner un exemple d'application qui montrera quelles sortes de contraintes doivent être respectées dans la réalisation du générateur.

L'exemple choisi est celui d'un circuit de télécommunications par ligne téléphonique, qui doit émettre des portions de sinusoïde de fréquence déterminée.

Les portions de sinusoïde sont définies sous forme d'une succession de mots numériques représentant les incréments positifs ou négatifs de signal analogique qu'il faut donner à chaque ins tant au signal pour que ce signal représente effectivement une portion de sinusoïde.

On pourrait imaginer que les mots numériques ne comportent qu'un bit représentant le signe d'un incrément : incrément +V ou -V ; mais alors la pente maximale de sortie du signal analogique est limitée puisque d'une période d'échantillonnage à la suivante on ne peut pas augmenter le signal analogique de plus d'un incrément. Or cet incrément a nécessairement une valeur relativement petite par rapport à l'amplitude globale du signal analogique, si on veut aussi pouvoir réaliser des pentes faibles pour le signal de sortie sans être obligé de prévoir la possibilité d'engendrer des incréments nuls (ce qu'on ne souhaite pas pour des raisons de mode de transmission).

C'est pourquoi on choisit plutôt de définir le signal analogique par des incréments ayant plusieurs amplitudes possibles ; dans l'exemple choisi pour illustrer le problème, les mots numériques ont trois bits permettant de définir cinq valeurs possibles qui sont une valeur centrale nulle, deux valeurs positives, et deux valeurs négatives égales en valeur absolue aux valeurs positives.

Mais, toujours dans cet exemple, on a prévu que les valeurs positives sont dans un rapport égal à trois l'une avec l'autre.

Autrement dit, si on appelle V la valeur de l'incrément de signal analogique élémentaire, les cinq valeurs d'incrément possibles sont :

$$- 3V \;, \; - V \;, \; O \;, \; V \;, \; 3V$$

On verra dans la suite que ce rapport 3 joue un rôle important (mais le rapport pourrait être différent, par exemple égal à 4 ou 5).

Les mots numériques peuvent être appliqués à une très grande fréquence d'entrée, le signal analogique de sortie se présentant sous forme d'un signal en marches d'escalier dans lequel la période d'échantillonnage est largement supérieure au double de la fréquence maximale du spectre du signal analogique à produire ; de cette manière il n'y a aucune difficulté à lisser le signal par un filtre passe-bas non échantillonné, placé en sortie du générateur.

Typiquement, la fréquence d'échantillonnage peut être de 15 MHz pour un signal analogique dont le spectre limité à 80 KHz.

Le principe de reconstitution d'un signal analogique par une suite de mots numériques représentant un très petit nombre d'incréments possibles est donc très intéressant car il permet de limiter la complexité des circuits de conversion numérique/analogique (il est plus facile de traiter 3 bits à haute fréquence que 12) et il facilite la réalisation du filtre de lissage en sortie (filtre qui est difficile à réaliser quand la fréquence d'échantillonnage est trop proche du double de la fréquence maximale du spectre du signal analogique à produire).

Mais pour que le générateur de forme d'onde donne satisfaction il faut alors que la valeur des incréments soit parfaitement bien déterminée, sans quoi le signal produit n'est pas celui que l'on voudrait. On conçoit cela facilement puisque l'on fait une intégration d'incréments successifs : un petit écart sur un incrément peut, s'il est répété de très nombreuses fois, aboutir à une perturbation très importante de la forme du signal produit.

Un des buts de l'invention est de réaliser un générateur de forme d'onde de signal analogique qui fournisse des incréments de signal aussi précis que possible, et en particulier des incréments qui sont dans des rapports extrêmement précis les uns avec les autres lorsque plusieurs valeurs d'incréments peuvent être engendrés en fonction du mot numérique d'entrée.

Le générateur de forme d'onde selon l'invention, destiné à produire un signal analogique à partir d'une séquence de mots numériques de commande dans laquelle chaque mot représente un incrément de signal analogique, est constitué sous forme d'un circuit à capacités commutées comprenant un amplificateur différentiel ayant au moins une entrée et au moins une sortie, avec une capacité d'intégration non commutée entre

2

la sortie et l'entrée, une capacité commutée de rebouclage entre l'entrée et la sortie, et plusieurs capacités commutées d'entrée nominalement identiques pouvant être commutées alternativement entre une tension de référence et l'entrée de l'amplificateur, soit individuellement soit en parallèle les unes avec les autres en fonction du mot numérique appliqué. Le générateur est caractérisé en ce qu'il comporte des moyens pour établir, avant une séquence d'élaboration d'un signal analogique, une phase de comparaison des capacités d'entrée les unes avec les autres pour déterminer la capacité d'entrée ayant la valeur la plus proche de la moyenne des valeurs des capacités d'entrée, et des moyens pour imposer l'utilisation de cette capacité lors d'une séquence ultérieure d'élaboration de signal analogique lorsque le mot numérique de commande implique la commutation d'une capacité individuelle entre la tension de référence et l'entrée de l'amplificateur.

Cette phase préparatoire de comparaison a pour but de déterminer quelle est la capacité la plus appropriée qu'il faut choisir parmi les différentes capacités individuelles d'entrée pour que l'incrément de signal analogique soit aussi proche de 3V que possible lorsque toutes les capacités d'entrée sont en parallèle, l'incrément étant V lorsque la capacité sélectionnée est commutée (dans le cas où les deux valeurs d'incrément possibles sont V et 3V, mais on comprendra que le problème est le même si les valeurs sont différentes).

Cette disposition permet de tenir compte, de la manière la plus efficace possible, de la dispersion qui peut exister entre les valeurs des capacités même si on a pris de grandes précautions lors de la fabrication pour avoir des capacités individuelles aussi identiques que possible.

En effet, on voudrait que le rapport entre les incréments de signal analogique soit précis à 1 pour mille près alors qu'il peut y avoir une dispersion de fabrication de 3 pour mille. L'invention permet d'obtenir cette amélioration.

Selon l'invention, on utilise de préférence l'amplificateur différentiel lui-même comme comparateur de charges lors de la phase de comparaison des valeurs de capacités.

On applique des tensions de référence de valeurs identiques à un premier groupe de deux capacités d'entrée, puis on relie les deux en parallèle à l'entrée de l'amplificateur, en les connectant dans un sens tel que les charges des deux capacités se compensent, l'amplificateur étant mis en boucle ouverte et sa sortie basculant dans un sens dépendant du sens de la différence entre les valeurs des deux capacités ; on répète ces opérations pour toutes les capacités d'entrée prises deux à deux, et on stocke à chaque fois dans un registre un bit correspondant au sens de basculement de l'amplificateur. Un décodeur reçoit les bits stockés dans le registre et fournit une indication de la capacité médiane de la suite de capacités classées dans un ordre croissant. C'est cette capacité qu'on utilisera et non les autres lorsqu' une seule capacité d'entrée devra être commutée pour l'élaboration du signal analogique.

De préférence, l'amplificateur différentiel possède deux entrées différentielles et deux sorties différentielles, et l'ensemble du circuit à capacités commutées est construit symétriquement autour de l'amplificateur. De préférence aussi, au cours de la phase de comparaison des capacités d'entrée, on utilise un mode de comparaison avec compensation de la ou les tensions de décalage d'entrée de l'amplificateur ; par tension de décalage d'entrée (ou tension "d'offset") on entend comme cela est classique la différence de potentiel présente entre une entrée et une tension de mode commun lorsque la sortie et l'entrée sont reliées entre elles.

D'autres caractéristiques et avantages de l'invention apparaîtront à la lecture de la description détaillée qui suit et qui est faite en référence aux dessins annexés dans lesquels :

la figure 1 représente un schéma bloc du circuit à capacités commutées formant le coeur du générateur selon l'invention ;

la figure 2 représente la configuration du circuit pendant une première phase de production d'un incrément de signal analogique, lors d'une séquence d'élaboration d'une forme d'onde ;

la figure 3 représente la configuration du circuit pendant une deuxième phase de production d'un incrément de signal analogique, lors d'une séquence d'élaboration d'une forme d'onde ;

la figure 4 représente la configuration du circuit pendant une phase d'initialisation lors d'un cycle de choix de la meilleure capacité d'entrée ;

la figure 5 représente la configuration du circuit pendant une phase de comparaison proprement dite de deux capacités d'entrée ;

la figure 6 représente un schéma bloc d'ensemble du générateur de forme d'onde selon l'invention.

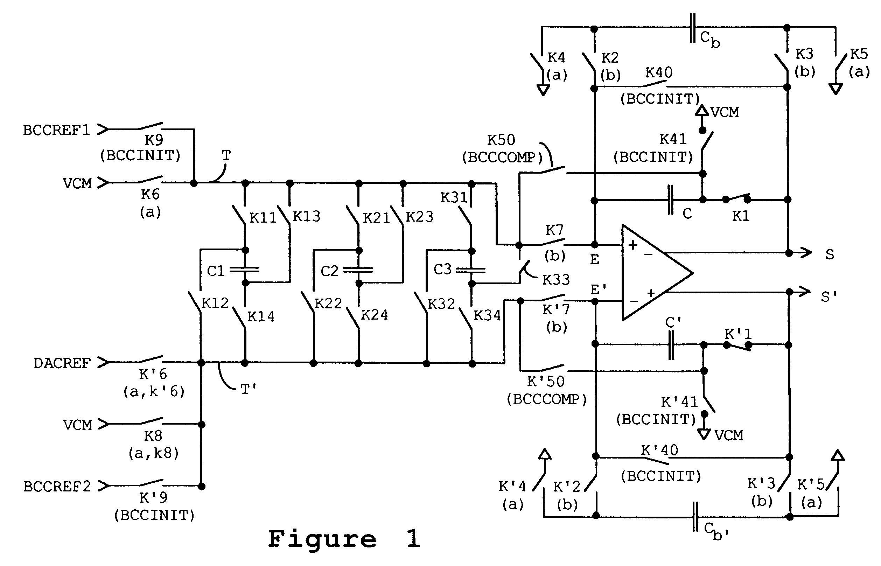

Le circuit de la figure 1 est un circuit à capacités commutées capable d'exécuter une fonction de conversion numérique/analogique. Il peut recevoir une séquence de mots de commande numériques à trois bits, appliqués à une fréquence d'horloge F. Une horloge non représentée définit des cycles de commutation des différents interrupteurs de la figure 1 de manière que les mots de commande numériques puissent se succéder à la fréquence F.

La fréquence F est par exemple de 15 MHz.

L'application d'un mot de commande engendre un incrément de potentiel en sortie du circuit et cet incrément a une valeur qui dépend du mot de commande.

Dans l'exemple particulier décrit ici, on a choisi le code de conversion suivant, dans lequel a0, a1, a2 représentent les trois bits du mot de commande et V une valeur élémentaire d'incrément. Les incréments possibles sont 0, V ou 3V, en positif ou en négatif.

| a0 | a1 | a2 | incrément |
|----|----|----|-----------|
| 1 | 1 | 1 | + 3 V |
| 1 | 0 | 1 | +  V |
| 1 | 0 | 0 |   0 |
| 0 | 1 | 1 |   0 |
| 0 | 1 | 0 | −  V |
| 0 | 0 | 0 | − 3 V |

L'incrément 0 n'est en réalité utilisé que pour des tests mais pas pour les phases de conversion proprement dites.

La génération d'un incrément + V consiste à transférer une charge CV dans une capacité d'intégration, cette charge s'ajoutant à la charge déjà existante. La génération d'un incrément - V consiste à transférer la même charge mais en soustraction. La génération d'un incrément 3 V ou -3 V consiste à transférer une charge triple de la précédente, en addition ou en soustraction respectivement.

Le circuit qui est représenté à la figure 1 est un circuit différentiel symétrique, bâti autour d'un amplificateur différentiel à deux entrées symétriques et deux sorties symétriques. Mais on pourrait imaginer un montage non symétrique.

L'amplificateur comporte une entrée E et une entrée E′, une sortie S et une sortie S′. La sortie S fournit un signal variant en sens inverse de l'entrée E, et de même la sortie S′ fournit un signal variant en sens inverse de l'entrée E′.

La sortie S est reliée à l'entrée E par une capacité d'intégration C et de même S′ et E′ sont reliées par une autre capacité d'intégration C′ de même valeur que C. Ces capacités ne sont pas des capacités commutées, c'est-à-dire qu'elles restent connectées entre l'entrée et la sortie pendant toute la durée des cycles d'élaboration de signal analogique. Toutefois on peut voir sur la figure 1 un interrupteur K1 et un interrupteur K′1 permettant de déconnecter la capacité C et la capacité C′ de la sortie S et de la sortie S′, respectivement. Ces interrupteurs seront ouverts seulement pendant la phase préliminaire BCC de choix de la meilleure capacité d'entrée. Ils sont fermés pendant le reste du temps c'est-à-dire pendant une phase BCC∗ complémentaire de la phase BCC.

Le circuit comporte encore deux capacités commutées de rebouclage identiques, respectivement Cb et Cb′, pouvant alternativement être connectées l'une en parallèle avec la capacité d'intégration C et l'autre en parallèle avec C′, ou être reliées par leurs deux bornes à la masse ou à une tension de mode commun VCM.

Les capacités de rebouclage ont une valeur nettement plus faible que les capacités d'intégration, par exemple 1 picofarad pour Cb et 13 picofarads pour C.

Ces capacités sont commutées à haute fréquence pendant l'élaboration d'un signal analogique, quatre interrupteurs K2, K3, K4, K5 pour la capacité Cb et quatre autres K′2, K′3, K′4, K′5 pour la capacité Cb′ permettant cette commutation.

Les autres capacités commutées du circuit sont les capacités d'entrée. Il y en a trois dans l'exemple décrit, C1, C2, C3.

Pour ces capacités, la commutation à haute fréquence permet de les connecter alternativement à des tensions de référence puis aux entrées de l'amplificateur différentiel.

Mais les interrupteurs permettant cette commutation sont nombreux afin de permettre qu'une capacité individuelle unique C1 ou C2 ou C3 subisse la commutation (charge par une tension de référence puis connexion à l'entrée de l'amplificateur) ou alors que les trois capacités d'entrée C1, C2, C3 subissent cette commutation en parallèle. De plus, le nombre d'interrupteurs est multiplié par deux pour permettre que la connexion aux entrées de l'amplificateur se fasse soit directement dans le sens où les capacités ont été chargées soit avec inversion de sens en croisant les connexions.

Ainsi, la capacité C1 est associée à quatre interrupteurs K11, K12, K13, K14 permettant de connecter chacune de ses bornes à l'un ou à l'autre de deux conducteurs T et T′ ; les conducteurs T et T′ peuvent être reliés à des tensions de référence ou aux entrées E et E′ de l'amplificateur différentiel par d'autres interrupteurs.

Plus précisément, pendant une première phase (phase a) de chaque cycle d'horloge (un cycle correspondant à l'application d'un nouveau mot de commande numérique d'incrémentation), une capacité commutée d'entrée C1 ou C2 ou C3 (si le mot de commande correspond à une incrémentation +V ou -V) ou les trois à la fois (si le mot de commande correspond à une incrémentation +3V ou -3V) est connectée entre une tension de référence de mode commun VCM et une tension de référence DACREF (tension de référence pour la conversion numérique/analogique).

Pour cela un interrupteur K6 permet de connecter le conducteur T à la tension VCM et un interrupteur K'6 permet de connecter le conducteur T' à la tension DACREF. Les interrupteurs K6 et K'6 sont fermés pendant la première phase (phase a) de chaque cycle d'horloge. Ils sont ouverts pendant la deuxième phase (phase b). Sur la figure 1, on a indiqué entre parenthèses à côté de chaque interrupteur la phase pendant laquelle il est fermé.

La connexion d'une capacité ou des trois capacités à la fois est déterminée par les interrupteurs K11 à K34, ainsi d'ailleurs que le sens de connexion pour imposer le sens de charge de la capacité, ou le sens de transfert ultérieur de cette charge.

Pendant la phase a, les capacités Cb et Cb' sont déchargées par fermeture des interrupteurs K4 et K5, K'4 et K'5 qui les relient à la tension de mode commun, les interrupteurs K2, K3, K'2, K'3 étant alors ouverts.

Les capacités C1, C2, C3 sont théoriquement indentiques, et leur valeur nominale est de préférence égale à la moitié de la valeur nominale commune des capacités commutées de rebouclage Cb et Cb'.

Pendant la deuxième phase (phase b) de chaque cycle d'horloge, la ou les capacités d'entrée préalablement chargées sont déconnectées des sources de tension VCM et DACREF (ouverture des interrupteurs K6 et K'6) et sont connectées aux entrées E et E' de l'amplificateur en même temps que les capacités de rebouclage déchargées Cb et Cb' sont reconnectées en parallèle sur les capacités d'intégration respectives C et C'.

La charge stockée dans la ou les capacités d'entrée se transfère alors dans la capacité d'intégration et la capacité de rebouclage, et elle donne lieu à un incrément de tension différentielle. L'incrément est positif ou négatif selon le sens de connexion des capacités d'entrée ; son amplitude est V ou 3 V selon qu'une seule capacité ou les trois capacités en parallèle sont utilisées pendant le cycle.

Pour la connexion des capacités d'entrée aux entrées E et E' pendant la phase b, on prévoit un interrupteur K7 entre le conducteur T et l'entrée E et un interrupteur K'7 entre le conducteur T' et l'entrée E'.

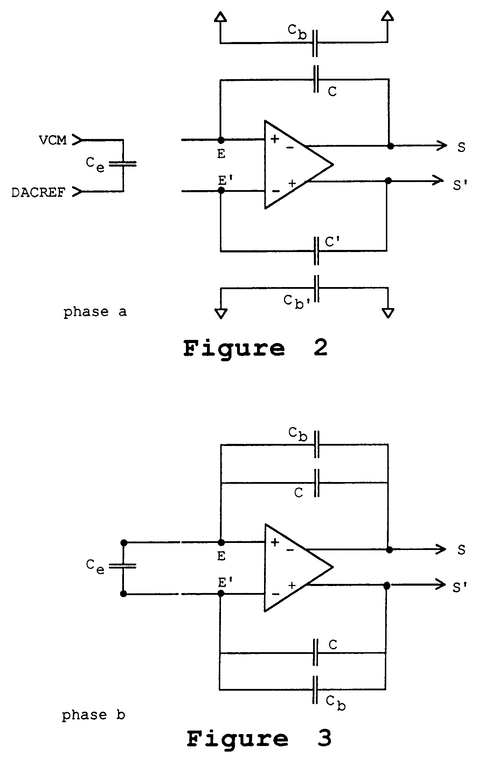

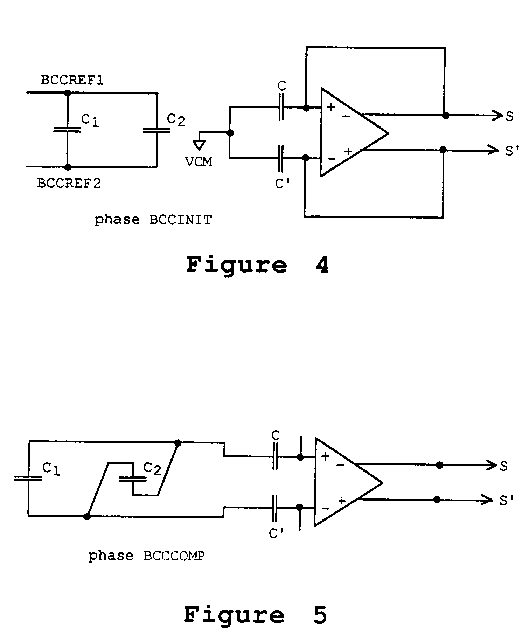

Pour résumer la phase a, on a représenté à la figure 2 la configuration générale du circuit pendant cette phase , la capacité d'entrée Ce est l'une des capacités C1, C2, ou C3 (pour obtenir un incrément d'amplitude V) ou les trois en parallèle (pour obtenir un incrément d'amplitude 3 V). La phase b est représentée à la figure 3 ; la capacité Ce est la même qu'à la figure 2 mais son sens de connexion dépend du signe qu'on veut obtenir pour l'incrément.

Pour mémoire, on peut noter sur la figure 1 un interrupteur K8 permettant de relier le conducteur T' à la tension de mode commun VCM, à des fins de test uniquement, l'incrément de sortie étant alors nul.

On va maintenant décrire les éléments de circuit permettant d'établir, préalablement aux phases d'élaboration d'une forme d'onde analogique désirée, une séquence BCC de choix de celle des capacités C1, C2, C3 qui est la plus appropriée pour obtenir la plus grande exactitude possible du rapport entre l'incrément V et l'incrément 3 V désirés théoriquement.

La séquence de choix se déroule en plusieurs étapes, et chaque étape comporte deux phases qu'on a appelé BCCINIT (initialisation) et BCCCOMP (comparaison proprement dite). Les différentes étapes correspondent à des comparaisons des différents capacités d'entrée deux à deux : par exemple d'abord les capacités C1 et C2 puis C2 et C3 puis C3 et C1.

Pendant la phase d'initialisation BCCINIT, on ferme un interrupteur K40 court-circuitant l'entrée E et la sortie S et un interrupteur K'40 court-circuitant l'entrée E' et la sortie S' ; simultanément, on ouvre les interrupteurs K1 et K'1 de sorte qu'une borne de la capacité C et de la capacité C', préalablement connectée à la sortie S et S' respectivement, est déconnectée ; cette borne est alors reliée à la tension de mode commun VCM par un interrupteur K41 pour la capacité C et K'41 pour la capacité C'.

Par ailleurs, toujours pendant la phase d'initialisation BCCINIT on ferme deux interrupteurs K9 et K9' permettant de relier respectivement le conducteur T et le conducteur T' à une première tension de référence BCCREF1 et à une deuxième tension de référence BCCREF2.

Enfin, on ferme quatre des interrupteurs K11 à K34 pour connecter deux capacités d'entrée choisies entre BCCREF1 et BCCREF2. Par exemple les capacités choisies au cours de l'étape en cours sont C1 et C2 et les interrupteurs fermés sont K11, K14, K21, K24 ; les autres sont ouverts.

On réalise donc pendant la phase d'initialisation deux opérations distinctes simultanées ; la première est une prise en mémoire des tensions d'offset de l'amplificateur dans les capacités d'intégration C et C' connectées chacune entre une entrée de l'amplificateur et la tension de mode commun VCM, l'amplificateur étant rebouclé en gain unitaire par un court-circuit entre l'entrée E et la sortie S d'une part et un court circuit entre l'entrée E′ et la sortie S′ d'autre part ; la deuxième opération est une charge des deux capacités à comparer avec une tension de référence commune égale à BCCREF1 - BCCREF2.

La figure 4 représente la configuration du circuit de la figure 1 pendant la phase d'initialisation BCCINIT d'une étape de comparaison de deux capacités d'entrée. On suppose ici que les capacités qu'on compare pendant cette étape sont les capacités C1 et C2 ; les étapes suivantes servent à la comparaison des autres groupes de capacités : C2 et C3 puis C3 et C1.

La phase qui suit est une phase de comparaison proprement dite des capacités d'entrée. Cette phase BCCCOMP consiste à utiliser l'amplificateur différentiel en comparateur basculant dans un sens ou dans un autre selon la tension appliquée entre ses entrées ; cette tension est la tension résiduelle présente aux bornes des capacités C1 et C2 à comparer lorsque celles-ci sont connectées en parallèle dans un sens tel que leurs charges tendent à se compenser.

Autrement dit, si on a chargé en parallèle C1 et C2 à une tension BCCREF1-BCCREF2 pendant la phase BCCINIT, on connecte à nouveau C1 et C2 en parallèle mais en croisant les connexions pendant la phase BCCCOMP pour que les charges se compensent ; si C1 et C2 sont rigoureusement identiques les charges se compensent rigoureusement et la tension aux bornes de C1 et C2 devient nulle; s'il y a une petite différence de valeur une charge résiduelle subsistera et une tension résiduelle apparaîtra aux bornes des capacités C1 et C2. Cette tension résiduelle, appliquée entre les entrées de l'amplificateur différentiel, fera basculer celui-ci dans un sens ou dans un autre, fournissant une indication sur les valeurs relatives des capacités d'entrée qu'on est en train de comparer. Les interrupteurs K40, K41, K′40, K′41 sont ouverts pendant cette phase BCCCOMP pour que l'amplificateur soit en boucle ouverte.

Le signal de sortie de l'amplificateur est stocké dans un registre non visible à la figure 1.

Pour prendre en compte l'existence des tensions d'offset de l'amplificateur, l'application de la tension résiduelle se fait à travers les capacités d'intégration qui ont été préalablement chargées pendant la phase d'initialisation par les tensions d'offset.

C'est pourquoi, sur la figure 1, on peut voir un interrupteur K50 permettant de relier pendant la phase BCCCOMP le conducteur T à celle des bornes de la capacité d'intégration C qui était reliée à VCM pendant la phase d'initialisation BCCINIT.

De même un interrupteur K′50 permet de relier la capacité C′ au conducteur T′.

La configuration du circuit pendant la phase de comparaison proprement dite BCCCOMP est représentée à la figure 5.

C'est par les interrupteurs K11 à K24 qu'on effectue le croisement des connexions des capacités C1 et C2 ; par conséquent si les interrupteurs K11, K14, K21, K24 étaient fermés pendant la phase BCCINIT, alors K11, K14, K22, K23 sont fermés pendant la phase BCCCOMP, les autres étant ouverts.

Ayant stocké dans un registre un bit indiquant laquelle des deux capacités C1 et C2 est la plus grande, on recommence l'opération pour un autre groupe de capacités, C2, C3 puis pour le dernier, C3, C1, et on stocke les bits correspondants dans le registre. Le décodage du contenu du registre (trois bits si on fait trois comparaisons) permet de classer les capacités en ordre croissant ou décroissant et de choisir la capacité médiane de la suite. C'est cette capacité qu'on utilisera dans les phases ultérieures d'élaboration de signal analogique pour avoir la plus grande précision possible sur le rapport entre les valeurs réelles des incréments théoriques V et 3V ou -V et -3V.

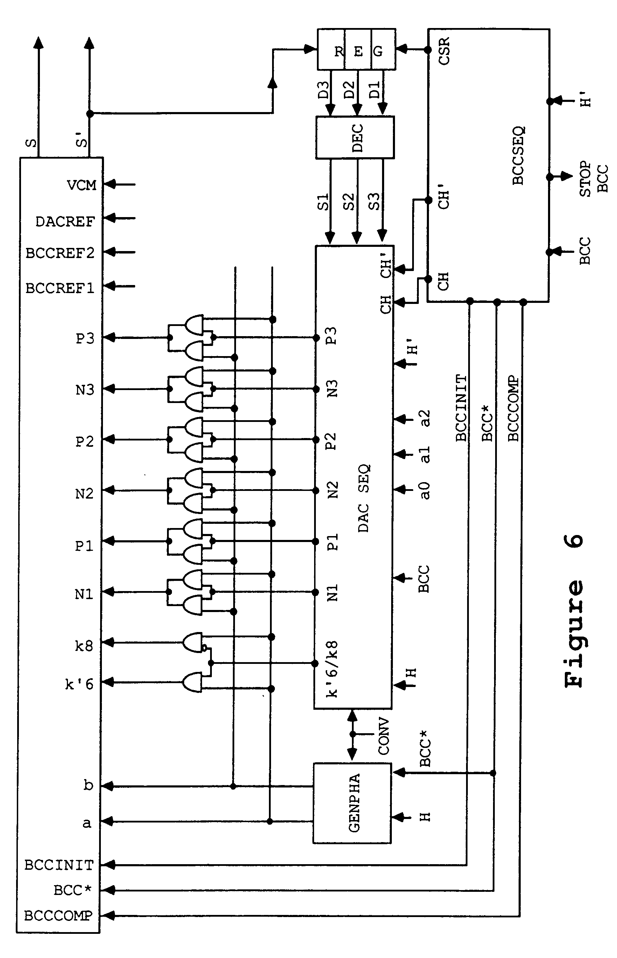

Le circuit global selon l'invention est représenté à la figure 6 sous forme d'un schéma bloc des différents organes nécessaires au fonctionnement des différents phases décrites précédemment.

Le circuit à capacités commutées de la figure 1 est repris sous forme d'un bloc SCF ayant un certain nombre de bornes d'alimentation et de commande dont on a déjà parlé et les deux sorties S et S′ fournissant le signal analogique désiré (en différentiel).

Les bornes de commande sont :

BCCCOMP : pour la réception d'un signal BCCCOMP indiquant qu'on est en phase de comparaison proprement dite de capacités d'entrée ;

BCCINIT : pour la réception d'un signal BCCINIT indiquant qu'on est en phase d'initialisation d'une étape de choix de la meilleure capacité ;

BCC* : pour la réception d'un signal BCC* indiquant qu'on n'est pas dans une étape de choix de la meilleure capacité.

a, b : pour la réception de signaux a, b indiquant qu'on est dans la phase a ou dans la phase b d'une étape de génération de forme d'onde de signal analogique.

N1 : pour la réception de signaux de commande de fermeture des interrupteurs K12 et K13 ;

P1 : pour la réception des signaux de fermeture des interrupteurs K11 et K14 ;

N2 : pour la réception des signaux de fermeture des interrupteurs K22 et K23 ;

P2 : pour la réception des signaux de fermeture des interrupteurs K21 et K24 ;

N3 : pour la réception des signaux de fermeture des interrupteurs K32 et K33 ;

P3 : pour la réception des signaux de fermeture des interrupteurs K31 et K34 ;

k8 et k'6 : pour la réception de signaux de commande de fermeture et d'ouverture de l'interrupteur K8 en mode de test et pour interdire alors la fermeture de l'interrupteur K'6.

Les bornes d'alimentation du circuit SCF sont :

BCCREF1 et BCCREF2 : tensions de référence pour les étapes de choix de la meilleure capacité d'entrée ;

DACREF : tension de référence pour les étapes de génération d'un signal analogique ;

VCM : tension de référence de mode commun.

Les signaux de commande de phase a et b sont produits par un générateur de phase GENPHA qui fonctionne à partir d'une horloge H à fréquence élevée (par exemple 15 MHz), mais seulement en dehors des phases de choix de la meilleure capacité. Ce générateur peut être déclenché par un signal CONV de début de conversion numérique/analogique.

Les signaux de commande k8, k'6, N1, P1, N2, P2, N3, P3 sont produits par un séquenceur de conversion numérique/analogique désigné par la référence DACSEQ. Ces signaux sont cependant synchronisés par les signaux issus du générateur de phase GENPHA de manière que les interrupteurs K11 à K34 mais aussi K6, K'6, K8 s'ouvrent et se ferment en synchronisme avec les phases a et b selon le processus expliqué en référence aux figures 1 à 3. Un ensemble de portes ET symbolise cette synchronisation entre les sorties du séquenceur DACSEQ et les entrées de commande du circuit SCF.

Le séquenceur DACSEQ exécute la succession des fermetures et ouvertures d'interrupteurs expliquée en référence aux figures 1 à 3, sous le contrôle de signaux qu'il reçoit et qui sont :

BCC : signal indiquant qu'on est dans une étape de choix de la meilleure capacité.

H : horloge à 15 MHz par exemple,

a0, a1, a2 : bits du mot de commande numérique indiquant quelle valeur et quel signe d'incrément de tension différentielle analogique doivent être produits entre les sorties S et S' ; ces signaux agissent en particulier sur le choix de ceux des signaux N1, N2, N3, PI, P2, P3 qui seront activés pendant l'élaboration de l'incrément.

S1, S2, S3 . signaux binaires dont deux sont à un niveau bas (par exemple) et un à un niveau haut, celui qui est à un niveau haut désignant quelle est à la capacité d'entrée, C1, C2 ou C3 qui doit être activée pour l'élaboration d'un incrément lorsque l'amplitude de l'incrément à produire est V.

Le séquenceur DACSEQ permet en outre de commander les fermetures et ouvertures des interrupteurs K11 à K34 pendant les étapes de choix de la meilleure capacité ; en effet, les interrupteurs K11 à K34 doivent être commandés pour accomplir les étapes résumées aux figures 4 et 5 et on peut utiliser les sorties du séquenceur DACSEQ pour exécuter ces commandes.

Le séquenceur DACSEQ reçoit à cet effet trois signaux de commande supplémentaires :

H' : horloge à plus basse fréquence, par exemple 2MHz, car les étapes de comparaison de capacités n'ont pas besoin de se faire à une fréquence aussi haute que la conversion numérique/analogique.

CH, CH' : deux bits indiquant quelle est la comparaison à faire : C1 avec C2, C2 avec C3 ou C3 avec C1.

Ces signaux de commande supplémentaires sont issus d'un autre séquenceur BCCSEQ qui élabore les séquences nécessaires à l'exécution de la procédure de détermination de la meilleure capacité.

Le deuxième séquenceur BCCSEQ fournit, outre les signaux CH et CH' définissant des choix des comparaisons à faire, le signal BCCINIT indiquant qu'on est en phase d'initialisation d'une étape de comparaison, et le signal BCCCOMP indiquant qu'on est en phase de comparaison proprement dite. Le séquenceur produit un premier couple de signaux CH, CH' et des signaux successifs BCCINIT et BCCCOMP, pour la comparaison d'un premier couple de capacités, puis un deuxième couple CH, CH' pour la comparaison de deux autres capacités, et des signaux BCCINIT et BCCCOMP correspondants. Lorsque les trois capacités d'entrée ont été comparées deux à deux, le séquenceur BCCSEQ émet un signal d'arrêt de la procédure de choix de la meilleure capacité (signal STOPBCC).

Le circuit séquenceur BCCSEQ est piloté par le signal d'horloge H', les signaux BCCINIT et BCCCOMP étant synchronisés par cette horloge (2MHz), et par un signal BCC définissant la durée de la procédure de choix de la meilleure capacité.

Le séquenceur BCCSEQ fournit enfin un signal CSR de décalage d'un registre à décalage REG dans lequel sont stockées les informations de valeurs relatives des capacités d'entrée.

Le registre à décalage REG reçoit sur une entrée série la sortie S' (par exemple) de l'amplificateur différentiel. L'état de la sortie S est pris en compte au moment de l'application d'une impulsion de décalage par le signal CSR, c'est-à-dire à la fin de chaque phase BCCCOMP.

Le registre a trois sorties en parallèle appliquées aux entrées d'un décodeur DEC à trois entrées et trois sorties.

Selon le contenu du registre REG à la fin de la procédure BCC de choix de la meilleure capacité, le décodeur fournit un niveau particulier sur l'une de ses trois sorties S1, S2, S3 et ce niveau désigne quelle est la capacité d'entrée C1, C2 ou C3 qui devra être utilisée par la suite lors de l'élaboration d'un incrément de signal analogique +V ou -V.

Cette désignation restera valable tant qu'on n'effectuera pas à nouveau une procédure BCC de choix de la meilleure capacité. Dans certains cas une seule procédure BCC suffira pour la durée de vie du circuit, au moment de sa première mise en oeuvre. Dans d'autres cas, on peut imaginer une vérification périodique (à chaque mise sous tension du circuit par exemple).

On peut imaginer la table de décodage suivante pour le décodeur DEC ; en supposant que D1, D2, D3 sont les bits stockés dans le registre REG ; D1 représentant un bit de résultat de la comparaison entre C1 et C2, avec D1 = 1 si C2 est supérieur à C1 et D1 = 0 dans le cas contraire ; D2 = 1 si C3 supérieur à C2 et D3 = 1 si C3 supérieur à C1 :

| D1 | D2 | D3 | | S1 | S2 | S3 | |
|----|----|----|--------|----|----|----|------------------------------|
| 0  | 0  | 0  |        | 0  | 1  | 0  | sélection de C2              |
| 0  | 0  | 1  | erreur | 1  | 0  | 0  | sélection de C1 par défaut   |
| 0  | 1  | 0  |        | 0  | 0  | 1  | sélection de C3              |
| 0  | 1  | 1  |        | 1  | 0  | 0  | sélection de C1              |
| 1  | 0  | 0  |        | 1  | 0  | 0  | sélection de C1              |
| 1  | 0  | 1  |        | 0  | 0  | 1  | sélection de C3              |
| 1  | 1  | 0  | erreur | 1  | 0  | 0  | sélection de C1 par défaut   |
| 1  | 1  | 1  |        | 0  | 1  | 0  | sélection de C2              |

Les cas d'erreur sont des cas d'incompatibilité des résultats des comparaisons ; ils viennent de ce que l'écart entre les capacités est très faible ; on sélectionne une capacité quelconque par défaut, par exemple C1.

On a ainsi décrit un générateur de forme d'onde fonctionnant par application d'une séquence de mots numériques à très haute fréquence et ayant une très bonne linéarité malgré le fait qu'il fonctionne par élaboration d'incréments pouvant avoir plusieurs valeurs différentes.

L'invention est applicable dans des cas où le rapport entre les valeurs d'incréments est différent de 3 ou dans le cas où plus de deux valeurs d'incréments sont utilisées. On peut imaginer par exemple qu'il y a trois amplitudes d'incréments possibles V, 3V, et 5V et qu'on effectue une procédure de classement de cinq capacités normalement identiques pour déterminer la capacité médiane des capacités arrangées en ordre croissant, pour ensuite sélectionner cette capacité si un incrément V doit être produit, pour sélectionner cette capacité et ses deux voisines dans la suite croissante si un incrément 3V doit être produit, les cinq capacités étant mises en parallèle lorsque l'incrément 5V doit être produit.

**Revendications**

1. Générateur de forme d'onde destiné à produire un signal analogique à partir d'une séquence de mots numériques de commande, chaque mot représentant un incrément de signal analogique à produire, le générateur comprenant un circuit à capacités commutées (SCF) comportant un amplificateur différentiel ayant au moins une entrée (E, E') et une sortie (S, S'), une capacité d'intégration non commutée (C, C') entre la sortie et l'entrée, une capacité commutée de rebouclage (Cb, Cb') entre la sortie et l'entrée, et plusieurs capacités commutées d'entrée (C1, C2, C3) nominalement identiques pouvant être commutées entre une tension de référence (DACREF) et l'entrée de l'amplificateur, soit individuellement soit en parallèle les unes avec les autres en fonction du mot numérique de commande appliqué, caractérisé en ce qu'il comporte des moyens (BCCSEQ) pour établir, avant une séquence d'élaboration de signal analogique, une phase de comparaison des capacités d'entrée les unes avec les autres pour déterminer la ca-

8

pacité d'entrée ayant la valeur la plus proche de la moyenne des valeurs des capacités d'entrée, et des moyens (REG, DEC) pour imposer l'utilisation de cette capacité d'entrée lors d'une séquence ultérieure d'élaboration de signal analogique lorsque le mot de commande appliqué implique la commutation d'une capacité d'entrée individuelle entre la tension de référence et l'entrée de l'amplificateur.

2. Générateur selon la revendication 1, caractérisé en ce que les moyens pour établir la phase de comparaison comportent un séquenceur pour

appliquer une tension de référence commune (BCCREF1 - BCCREF2) à un premier groupe (C1, C2) de deux capacités d'entrée,

appliquer les capacités chargées en parallèle à l'entrée de l'amplificateur en croisant leurs connexions de manière que leurs charges se compensent, l'amplificateur étant mis en boucle ouverte et sa sortie basculant dans un sens dépendant du sens de la différence de valeur entre les deux capacités,

répéter ces opérations pour toutes les capacités d'entrée prises deux à deux (C2, C3 ; C3, C1) et stocker à chaque fois une information correspondant au sens de basculement.

3. Générateur selon la revendication 2, caractérisé en ce qu'il comporte un registre (REG) de stockage des informations de sens de basculement, et un décodeur en sortie du registre, le décodeur fournissant une détermination de la capacité d'entrée ayant une position médiane dans la suite de valeur croissante ou décroissante des capacités d'entrée comparées deux à deux.

4. Générateur selon la revendication 2, caractérisé en ce que les capacités d'entrée sont appliquées avec leurs connexions croisées à l'entrée de l'amplificateur à travers d'autres capacités (C, C′) dans lesquelles ont été préalablement chargées les tensions d'offset de l'amplificateur différentiel.

5. Générateur selon l'une des revendications 1 à 4, caractérisé en ce que l'amplificateur est un amplificateur différentiel symétrique à deux entrées différentielles (E, E′) et deux sorties différentielles (S, S′) et en ce que l'ensemble du circuit à capacités commutées est construit symétriquement par rapport à l'amplificateur différentiel.

## Patentansprüche

1. Wellenformgenerator zum Erzeugen eines analogen Signals aus einer Sequenz numerischer Befehlsworte, wobei jedes Wort ein Inkrement eines zu erzeugenden analogen Signales darstellt, wobei der Generator eine geschaltete Kapazitätsschaltung (SCF) mit einem Differenzverstärker mit mindestens einem Eingang (E, E′) und einem Ausgang (SS′), einem nicht geschalteten Integrationskondensator (C, C′) zwischen Ausgang und Eingang, einem geschalteten Rückkopplungskondensator (Cb, Cb′) zwischen dem Ausgang und dem Eingang und mehreren geschalteten Eingangskondensatoren (C1, C2, C3) aufweist, die in ihrem Wert identisch sind und zwischen eine Referenzspannung (DACREF) und den Eingang des Verstärkers entweder einzeln oder parallel zueinander als Funktion des angelegten numerischen Befehlswortes geschaltet werden können, dadurch gekennzeichnet, daß eine Einrichtung (BCCSEQ) vorgesehen ist, um vor einer Bearbeitungsfolge des analogen Signals einen Phasenvergleich der Eingangskondensatoren untereinander vorzunehmen, um den Eingangskondensator zu bestimmen, der den nächsten Wert in bezug auf den mittleren Wert der Eingangskondensatoren aufweist, und daß Einrichtungen (REG, DEC) vorgesehen sind, um diesen Eingangskondensator während einer letzten Bearbeitungsfolge des analogen Signals zu verwenden, wenn das angelegte Befehlswort die Schaltung eines einzelnen Eingangskondensators zwischen die Referenzspannung und den Eingang des Verstärkers verlangt.

2. Generator nach Anspruch 1, dadurch gekennzeichnet, daß die Einrichtung zum Ausführen eines Phasenvergleichs einen Sequenzer aufweist, um

eine gemeinsame Referenzspannung (BCCREF1 bis BCCREF2) an eine erste Gruppe (C1, C2) aus zwei Eingangskondensatoren anzulegen,

die geladenen Kondensatoren parallel an den Eingang des Verstärkers zu schalten, wobei ihre Verbindungen derart über Kreuz geschaltet werden, daß sich ihre Ladungen kompensieren, und wobei der Verstärker in eine offene Rückkopplung gesetzt und sein Ausgang in eine Richtung geschaltet wird, die von der Richtung der Differenz des Wertes der beiden Kondensatoren abhängt,

diese Operationen für alle, jeweils zu zweit genommenen Eingangskondensatoren (C2, C3; C3, C1) zu wiederholen und jedesmal eine Information hinsichtlich der Richtung der Schaltung zu speichern.

3.  Generator nach Anspruch 2, dadurch gekennzeichnet, daß ein Speicherregister (REG) für Informationen der Schaltungsrichtung sowie ein Dekoder am Ausgang des Registers vorgesehen sind, wobei der Dekoder denjenigen Eingangskondensator bestimmt, der eine mittlere Stellung in der Folge der ansteigenden oder absteigenden Werte der jeweils in Paaren verglichenen Eingangskondensatoren einnimmt.

4.  Generator nach Anspruch 2, dadurch gekennzeichnet, daß die Eingangskondensatoren mit ihren Überkreuzverbindungen am Eingang des Verstärkers über andere Kondensatoren (C, C′) angelegt werden, in denen vorab die Offset-Spannungen des Differenzverstärkers geladen sind.

5.  Generator nach einem der Ansprüche 1 bis 4, dadurch gekennzeichnet, daß der Verstärker ein symmetrischer Differenzverstärker mit zwei Differenzeingängen (E, E′) und zwei Differenzausgängen (S, S′) ist, und daß die Schaltungsanordnung mit den geschalteten Kondensatoren symmetrisch in bezug auf den Differenzverstärker ausgebildet ist.

## Claims

1.  A waveform generator designed to supply an analog signal from a sequence of digital control words, each word representing an increment of the analog signal to be produced, the generator comprising a switched-capacitor circuit (SCF) including a differential amplifier having at least one input (E, E′) and one output (S, S′), a non switched integration capacitor (C, C′) between the output and the input, a feedback switched-capacitor (Cb, Cb′) between the output and the input, and several input switched-capacitors (C1, C2, C3) with the same nominal value and switchable between a reference voltage (DACREF) and an amplifier input, either individually or in parallel as a function of the digital control word applied, characterized in that it comprises means (BCCSEQ) for establishing, prior to an analog signal formation sequence, a comparison phase of the input capacitors for determining the input capacitor having the closest value to the average value of the input capacitors, and means (REG, DEC) for selecting the use of this input capacitor during a subsequent formation sequence of an analog signal when the applied control word denotes switching of an individual input capacitor between the reference voltage and the amplifier input.

2.  A generator according to claim 1 wherein said means for establishing a comparison phase comprise a sequencer for
    applying a common reference voltage (BCCREF1-BCCREF2) to a first group (C1, C2) of two input capacitors,
    connecting the charged capacitors in parallel to the amplifier input by crossing their connections so that their charges are counterbalanced, the amplifier being set in open loop and its output state switching in a direction depending upon the sign of the difference between the two capacitors,
    repeating these operations for all the pairs of input capacitors (C2, C3; C3, C1) and each time storing an indication corresponding to the switching direction.

3.  A generator according to claim 2 comprising a register (REG) for storing the switch data and a decoder at the output of the register, said decoder determining the input capacitor having a median position in the sequence of ascending or descending values of the input capacitors compared by pair.

4.  A generator according to claim 2 wherein the input capacitors are connected with their connections crossed at the amplifier input, through other capacitors (C, C′) wherein the offset voltages of the differential amplifier have been previously charged.

5.  A generator according to claim 1 wherein said amplifier is a symmetric differential amplifier with two differential inputs (E, E′) and two differential outputs (S, S′) and said switched-capacitor circuit is symmetrically constructed with respect to the differential amplifier.

Figure 1

phase a

## Figure 2

phase b

## Figure 3

phase BCCINIT

**Figure 4**

phase BCCCOMP

**Figure 5**

Figure 6